# EUROPEAN PATENT APPLICATION

(11) **EP 4 570 582 A1**
(43) Date of publication of application: **18.06.2025**
(21) Application number: 22959635.8
(22) Date of filing: 25.11.2022
(51) Int. Cl.: B60L 58/16, G01R 31/367, G01R 31/392, H01M 10/42, G06Q 10/083

(54) **DEVICE FOR PROVIDING BATTERY STATE INFORMATION, AND OPERATING METHOD THEREFOR**

(30) Priority: 19.09.2022 KR 20220118199
(71) Applicant: LG Energy Solution, Ltd., Seoul 07335 (KR)
(72) Inventor: LEE, Ko Woon, Daejeon 34122 (KR)
(74) Representative: Plasseraud IP
(86) International application number: PCT/KR2022/018820
(87) International publication number: WO 2024/063205

(57) **Abstract**

A battery state information providing apparatus according to an embodiment includes a generator configured to generate experimental profiles and a driving profile based on experimental life indexes and a driving life indexes, a comparator configured to compare the experimental profiles and the driving profile to determine an evaluation profile among the experimental profiles, and an evaluator configured to determine state information on a target battery pack based on the evaluation profile and a target life index, wherein the target life index may be a driving life index of a vehicle including the target battery pack.

## Description

### TECHNICAL FIELD

### CROSS-REFERENCE TO RELATED APPLICATION

This application claims priority to Korean Patent Application No. 10-2022-0118199, filed September 19, 2022, the entire contents of which is incorporated herein for all purposes by this reference.

### TECHNICAL FIELD

Embodiments disclosed in this document relate to a battery state information providing apparatus and an operation method thereof.

### [BACKGROUND ART]

Recently, research and development on secondary batteries have been actively conducted. Here, the secondary battery is a rechargeable battery and includes all of the conventional Ni/Cd batteries, Ni/MH batteries, and recent lithium ion batteries. Among the secondary batteries, Lithium ion batteries have an advantage of much higher energy density than the conventional Ni/Cd batteries and Ni/MH batteries. In addition, lithium-ion batteries can be manufactured small and lightweight enough to be used as power sources for mobile devices and recently expand their usage range to power sources for electric vehicles, attracting attention as a next-generation energy storage medium.

The battery mounted on an electric vehicle shows a deteriorating tendency as it is repeatedly charged and discharged. For example, as the battery mounted in an electric vehicle is repeatedly charged and discharged for driving the electric vehicle, it deteriorates in capacity and resistance, resulting in decrease of remaining life. Meanwhile, degree of degradation and remaining life of the battery may change depending on operating conditions of the electric vehicle.

A rapid decrease in the remaining life of the battery may cause safety problems in the use of the electric vehicles. Therefore, there is a need for a method of diagnosing the state of a battery mounted in an electric vehicle in advance, preventing risk of a sudden drop in battery performance, and providing battery state information to a user.

### [DISCLOSURE]

### [TECHNICAL PROBLEM]

An object of the embodiments disclosed in this document is to provide an apparatus for determining the state of a target battery pack mounted in a vehicle based on an experimental life index and driving life index and providing information on the state of the battery pack and an operation method thereof.

An object of the embodiments disclosed in this document is to provide an apparatus for determining the state of a target battery pack mounted in a vehicle by comparing experimental profiles based on experimental life indexes and a driving profile based on driving life indexes collected by the vehicle and vehicles of the same model as the vehicle and providing information on the state of the battery pack and an operation method thereof.

The technical objects of the embodiments disclosed in this document are not limited to the aforesaid, and other objects not described herein with be clearly understood by those skilled in the art from the descriptions below.

### [TECHNICAL SOLUTION]

A battery state information providing apparatus according to an embodiment includes a generator configured to generate experimental profiles and a driving profile based on experimental life index and a driving life index, a comparator configured to compare the experimental profiles and the driving profile to determine an evaluation profile among the experimental profiles, and an evaluator configured to determine state information on a target battery pack based on the evaluation profile and a target life index, wherein the target life index may be a driving life index of a vehicle including the target battery pack.

According to an embodiment, the experimental profiles may be profiles in which the experimental life index of the battery pack for a preset experimental driving condition are arranged with respect to a driving distance.

According to an embodiment, the driving profile may be a profile in which the driving life index collected from the vehicle and vehicles of the same model as the vehicle are arranged with respect to a driving distance.

According to an embodiment, the comparator may be configured to determine a continuous reference profile for an entire driving distance based on the driving profile.

According to an embodiment, the comparator may be configured to determine, as a first evaluation profile, an experimental profile having a higher experimental life index than the reference profile and having the smallest slope for the entire driving distance.

According to an embodiment, the comparator may be configured to determine, as a second evaluation profile, an experimental profile having a lower experimental life index than the reference profile and having the largest slope for the entire driving distance.

According to an embodiment, the comparator may be configured to determine an experimental profile having the highest degree of agreement with the driving profile among the experimental profiles as the reference profile.

According to an embodiment, the comparator may be configured to generate the reference profile by linearly interpolating the driving profile.

According to an embodiment, the evaluator may be configured to authenticate the state information and provide the authenticated state information to an external device.

According to an embodiment, the state information may include performance information, safety information, or price information on the target battery pack.

A battery state information provision system according to another embodiment of the present invention may include a vehicle comprising a target battery pack and a controller configured to transmit a driving life index for the target battery pack, a battery state information providing apparatus configured to receive experimental life indexes and a driving life index and determine state information on the target battery pack based on the experimental life indexes and the driving life index, and an external device configured to output the state information on the target battery pack.

According to another embodiment, the external device may be configured to output the state information to an authenticated user.

According to another embodiment, the experimental life index may be life index of the battery pack under a preset experimental driving condition.

According to another embodiment, the driving life index may be a life index collected from the vehicle and vehicles of the same model as the vehicle.

An operation method of a battery state information provision system according to another embodiment of the present invention includes receiving, at a generator, driving life indexes from a vehicle including a target battery pack and vehicles of the same model as the vehicle, receiving, at the generator, experimental life indexes, generating, at the generator, experimental profiles and a driving profile based on the experimental life indexes and the driving life indexes, determining, at a comparator, an evaluation profile among the experimental profiles by comparing the experimental profiles with the driving profile, determining, at an evaluator, state information on the target battery pack based on the evaluation profile and a target life index, providing, at the evaluator, the state information on the target battery pack to an external device, and outputting, at the external device, the state information on the target battery pack, wherein the target life index may be a driving life index of the vehicle.

According to another embodiment, the experimental profiles may be profiles in which the experimental life indexes of the battery pack for a preset experimental driving condition are arranged with respect to a driving distance.

According to another embodiment, the driving profile may be a profile in which the driving life indexes collected from the vehicle and vehicles of the same model as the vehicle are arranged with respect to a driving distance.

According to another embodiment, determining the evaluation profile may include determining, at the comparator, a continuous reference profile for an entire driving distance based on the driving profile, determining, as a first evaluation profile, an experimental profile having a higher experimental life index than the reference profile and having the smallest slope for the entire driving distance, and determining, as a second evaluation profile, an experimental profile having a lower experimental life index than the reference profile and having the largest slope for the entire driving distance.

According to another embodiment, determining the reference profile may include determining an experimental profile having the highest degree of agreement with the driving profile among the experimental profiles as the reference profile.

According to still another embodiment, determining the reference profile may include generating the reference profile by linearly interpolating the driving profile.

### [ADVANTAGEOUS EFFECTS]

A battery state information providing apparatus and an operation method thereof according to an embodiment disclosed in this document are capable of reliably determining state information of a battery pack mounted in a vehicle based on an experimental life index and an driving life index.

The state information on a battery pack according to an embodiment disclosed in this document may include performance information, safety information, or price information on the target battery pack mounted in a vehicle, and the state information providing apparatus provides the state information on the target battery pack to a user, allowing the user to manage the battery pack efficiently.

A battery state information providing apparatus and an operation method thereof according to an embodiment disclosed in this document are capable of authenticating state information on a battery pack mounted in a vehicle and providing the authenticated state information via an external device in order for a secondary purchaser who wants to purchase the vehicle to prepare, on the basis of the accurate information on the state of the battery pack of the vehicle, for risk factors and dispute factors that may occur after purchasing the vehicle.

In addition, various effects identified directly or indirectly through this document can be provided.

### [DESCRIPTION OF DRAWINGS]

FIG. 1 is a block diagram illustrating a configuration of a general battery pack;
FIG. 2 is a block diagram illustrating a battery state information providing apparatus according to an embodiment disclosed in this document;
FIG. 3 is a diagram for explaining an operating method of a battery state information provision system according to an embodiment disclosed in this document;
FIG. 4 is a diagram for explaining a method of determining an evaluation profile among a plurality of experimental profiles by a battery state information providing apparatus according to an embodiment disclosed in this document;
FIG. 5 is a diagram for explaining a method of determining a reference profile by a battery state information providing apparatus according to another exemplary embodiment disclosed in this document;
FIG. 6 is a diagram for explaining a method of determining state information on a target battery pack by a battery state information providing apparatus according to an embodiment disclosed in this document;
FIG. 7 is a diagram illustrating an exemplary battery state information provision screen according to an embodiment disclosed in this document;
FIG. 8 is a flowchart illustrating an operation method of a battery state information provision system according to an embodiment disclosed in this document.
FIG. 9 is a flowchart illustrating an operation method of a battery state information provision system according to another embodiment disclosed in this document; and
FIG. 10 is a block diagram illustrating a hardware configuration of a computing system for performing an operation method of a battery state information providing apparatus or a battery state information provision system according to an embodiment disclosed in this document.

### [MODE FOR INVENTION]

Hereinafter, embodiments disclosed in this document will be described in detail with reference to exemplary drawings. In assigning reference numerals to the components of each drawing, it should be noted that the same components have the same reference numerals as much as possible even if they are displayed in different drawings. Detailed description of a well-known structure or function incorporated in the embodiments disclosed in this document may be omitted to avoid obscuring the understanding of the embodiments disclosed in this document.

Terms such as "the first", "the second", "A", "B", "(a)", and "(b)" may be used to describe components of the embodiments disclosed in this document. These terms are only used only to distinguish one component from another component, and the nature, sequence, or order of the corresponding components are not limited by the term. Unless otherwise defined herein, all terms including technical or scientific terms used herein have the same meanings as commonly understood by those skilled in the art to which the embodiments disclosed in this document belongs. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

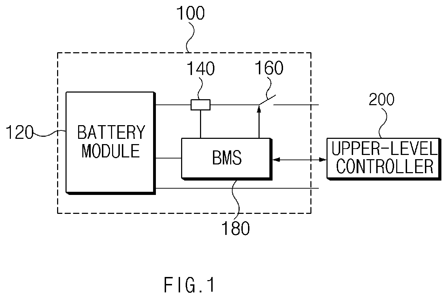

FIG. 1 is a block diagram illustrating a configuration of a general battery pack.

FIG. 1 schematically illustrates a battery control system including a battery pack 100 according to an embodiment of the present invention and an upper-level controller 200 included in an upper-level system.

As shown in FIG. 1, the battery pack 100 includes a battery module 120 composed of one or more battery cells and capable of being charged and discharged, a switching unit 160 connected in series to the positive terminal side or the negative terminal side of the battery module 120 to control the flow of charging and discharging current of the battery module 120, and a battery management system 180 (e.g., RBMS) that controls and manages the battery pack 100 to prevent overcharging and over-discharging and monitors data on the battery module 120. Here, the battery pack 100 may include a plurality of battery modules 120, sensors 140, switching units 160, and battery management systems (BMSs) 180.

The sensor 140 is connected between the battery module 120 and the battery management system 180 to sense the voltage, current, temperature, and internal resistance and impedance of the battery module 120, which may be transmitted to the battery management system 180.

The switching unit 160 is a device for controlling the flow of current for charging or discharging the battery module 120 and, by way of example, at least one relay or magnetic contactor may or the like may be used depending on the specifications of the battery pack 100.

The battery management system 180 is an interface for receiving measurement values of various parameters described above and may include a plurality of terminals and a circuit connected to the terminals to process the input values. **In** addition, the battery management system 180 may control ON/OFF of the switching unit 160, for example, a relay or a contactor, and is connected to the battery module 120 to monitor the state of each battery module 120.

The upper-level controller 200 may transmit a control signal for the battery pack 100 via the battery management system 180. The operation of the battery management system 180 may be controlled based on the signal from the upper-level controller 200.

According to an embodiment, the battery pack 100 and the upper-level controller 200 may be provided in a vehicle and the battery management system 180 may receive data such as voltage, current, temperature, internal resistance, impedance, and charge and discharge counts of the battery modules 120 from the sensor 140.

The data of the battery module 120, such as voltage, current, temperature, internal resistance, impedance, and charge and discharge counts, may be data providing a basis for determining state information on battery pack 100 included in the vehicle.

The battery management system 180 may transmit the data to the upper-level controller 200, and the upper-level controller 200 may perform calculation on the data to generate a life index for the battery pack 100. The generated life index may be transmitted to an external device (e.g., a state information providing apparatus).

For example, the life index may mean state of health (SOH), a figure of merit obtained by comparing the ideal state of the battery pack 100 with the current state of the battery pack 100. SOH may be an index indicating the remaining life and current performance state of the battery pack 100.

According to an embodiment, SOH may be calculated based on the charge rate and discharge rate of the battery pack 100. The charge rate and discharge rate of the battery pack 100 may be obtained by calculating the difference in capacity between a fully charged state and a completely discharged state of the battery pack and, by way of example, the SOH may be calculated based on the data about voltage, current, temperature, internal resistance, or impedance of the battery pack.

According to an embodiment, the battery pack 100 may include a plurality of battery modules 120 and, in this case, the data such as voltage, current, temperature, internal resistance, impedance, and charge and discharge counts output from an arbitrary battery module 120 may be selected as basic data for generating a life index of the battery pack 100.

According to another embodiment, the battery management system 180 may calculate the life index for each battery module 120 based on data such as voltage, current, temperature, internal resistance, impedance, and charge and discharge counts of the battery module 120 and calculate the life index of the battery pack 100 based on the calculated life index of each battery module 120. That is, the life index may be calculated by the battery management system 180 or the upper-level controller 200.

It may be possible to perform charge and discharge cycles with the battery pack 100 mounted on an actual running vehicle or simulate the charge and discharge cycles under experimental driving conditions similar to the actual driving conditions of the vehicle.

For example, a life index of the battery pack 100 calculated based on data, such as voltage, current, temperature, internal resistance, impedance, and charge and discharge counts, output from the battery module 120 of a vehicle in actual running may be referred to as a driving life index. **In** addition, a life index of the battery pack calculated based on data, such as voltage, current, temperature, internal resistance, impedance, and charge and discharge counts, output from the battery module 120 in a simulation of charge and discharge cycles performed under experimental driving conditions may be referred to as an experimental life index.

The driving conditions preset for generating the experimental life index may include, for example, an acceleration driving condition, a fast charging condition, a city driving condition, or a long-distance driving condition of the vehicle. **In** addition, the preset driving conditions may reflect the driving environment of the vehicle, the type of vehicle, and the charge and discharge cycles.

That is, the preset driving conditions may refer to exemplary driving scenario conditions including the behavior of the vehicle and the operating environment of the vehicle.

The data for generating the experimental life index and the generated experimental life index may be stored in an external server or database.

The driving life index may be data obtained when a vehicle including the battery pack 100 actually drives. According to an embodiment, the driving life index may be influenced by a driver's driving habit, the environment in which the vehicle actually operates, and actual charge and discharge cycles of the battery.

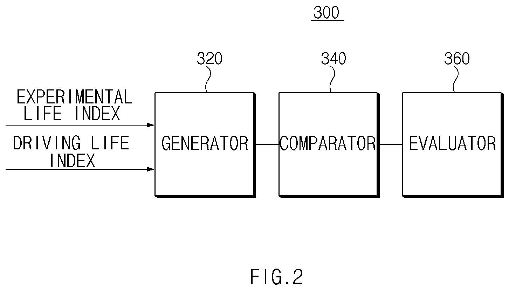

FIG. 2 is a block diagram illustrating a battery state information providing apparatus according to an embodiment disclosed in this document.

The battery state information providing apparatus 300 may include includes a generator 320 generating experimental profiles and driving profiles by arranging experimental life indexes and driving life indexes with respect to the driving distance, a comparator 340 configured to compare the experimental profiles with the driving profiles to determine a first evaluation profile and a second evaluation profile among the experimental profiles, and an evaluator 360 determining state information on a target battery pack based on the first and second evaluation profiles and a target life index.

The generator 320 may generate a plurality of experimental profiles by arranging the experimental life indexes with respect to the driving distance. The generator 320 may also generate a driving profile by arranging driving life indexes with respect to driving distance.

According to an embodiment, a profile may be a two-dimensional curve representing a change in life index (e.g., SOH) according to a driving distance.

The experimental life indexes may be classified according to preset experimental driving conditions. That is, the experimental life indexes may constitute different experimental profiles respectively corresponding to preset experimental driving conditions.

According to an embodiment, the experimental life indexes may be obtained for the entire driving distance, and the experimental profile may be displayed as a continuous curve with respect to a plane having the life index and the driving distance as axes.

The generator 320 may receive the driving life indexes from the vehicle including the battery pack as a target of state information determination and vehicles of the same model as the vehicle. The vehicle and vehicles of the same model as the vehicle may have different driving distances, and the driving profile may be displayed as a set of discrete points on a plane having the life index and the driving distance as axes.

The generator 320 may receive the experimental life indexes and driving life indexes from an external server or database. According to an embodiment, the external server or database may be a platform that collects driving life indexes from a plurality of vehicles including the battery pack 100 and integrally manages the driving life indexes.

The comparator 340 may compare a plurality of experimental profiles with a driving profile and determine a first evaluation profile and a second evaluation profile from the experimental profiles.

The comparator 340 may determine a reference profile, which is a continuous curve for the entire driving distance, based on the driving profile. The first and evaluation profiles may be easily selected among the experimental profiles by determining a continuous reference profile for the entire driving distance.

Also, by determining the reference profile, the battery state information providing apparatus 300 may reflect a change tendency of the driving life index in determining the state of the battery pack.

According to an embodiment, the comparator 340 may determine an experimental profile having the highest degree of agreement with the driving profile as a reference profile or generate a reference profile by linearly interpolating the driving profile.

The comparator 340 may determine an evaluation profile using the reference profile and the experimental profiles. The evaluation profile may be a profile for evaluating the current state of the battery pack mounted in the vehicle and may include a first evaluation profile or a second evaluation profile.

According to an embodiment, the first evaluation profile may be a profile for use in determining the excellent or good state of the target battery pack as a target of state evaluation, and the second evaluation profile may be a profile for use in determining the excellent or management-required state of the target battery pack.

According to an embodiment, the comparator 340 may not determine some experimental profiles as evaluation profiles. For example, the comparator 340 may not determine the experimental profiles in which a change in life index is less than a preset value for the entire driving distance (e.g., change in SOH is less than 5% for the entire driving distance) or the life index tends to be lower than the lowest life index (e.g., SOH is less than 80%) as first evaluation profile or the second evaluation profile.

That is, the comparator 340 determines the experimental profiles in which the change in life index is less than a preset value or the life index tends to be lower than the lowest life index for the entire driving distance as inappropriate for evaluating the state of the battery pack and thus does not select them as an evaluation profile.

According to an embodiment, the comparator 340 may determine, as the first evaluation profile, an experimental profile having an experimental life index higher than the determined reference profile and having the smallest slope for the entire driving distance. The comparator 340 may also determine, as the second evaluation profile, an experimental profile having an experimental life index lower than the determined reference profile and having the largest slope for the entire driving distance.

As the first and second evaluation profiles are selected by the comparator 340 according to an embodiment, the shorter the driving distance, the narrower the area determined to be in a good state, and the longer the driving distance, the wider the area determined to be in a good state. The battery state information providing apparatus 300 according to an embodiment of the present invention may determine the battery state based on a stricter criterion as the driving distance is shorter and more leniently determine the battery state as the driving distance is longer.

The evaluator 360 may determine state information on target battery pack based on the first evaluation profile, the second evaluation profile, and the target life index.

According to an embodiment, the target life index may be a driving life index of a vehicle including a target battery pack. The driving life index may be a driving life index corresponding to a distance traveled by the vehicle until the state information on battery pack is determined.

The evaluator 360 may determine that the state of the target battery pack is excellent when the target life index is located above the first evaluation profile.

An excellent state of the target battery pack may mean that the target life index, which is the driving life index of the target battery, is high compared to the change tendency of the driving life indexes.

The evaluator 360 may determine that the target battery pack is in a good state when the target life index is located below the first evaluation profile and above the second evaluation profile.

A good state of the target battery pack may mean that the change tendency of the driving life indexes is similar to the target life index.

The evaluator 360 may determine the state of the target battery pack as a state requiring management when the target life index is located below the second evaluation profile.

The state requiring management may mean that management such as driving and charging pattern change and battery replacement is required because the target life index of the target battery is low compared to the change tendency of the driving life indexes.

The evaluator 360 may authenticate or guarantee the determined state information on the battery pack. Also, the state information on the battery pack that is determined by the evaluator 360 may include performance information, safety information, or price information on the battery pack.

According to an embodiment, the evaluator 360 may generate the information on the performance of the battery pack based on the target life index of the target battery pack and the maximum performance of the battery.

The evaluator 360 may generate information on the safety of the battery pack based on the driving distance of the vehicle and the target life index of the target battery pack. For example, when the target life index is evaluated as excessively low compared to the driving distance of the vehicle, the evaluator 360 may determine that there is a problem with the safety of the battery pack.

The evaluator 360 may generate the price information on the battery pack based on the target life index of the target battery pack. For example, the evaluator 360 may predict the price of the battery pack by calculating the decrease in value of the battery pack arithmetically based on the target life index value compared to the maximum performance of the battery.

The evaluator 360 may transmit the generated state information on a target battery pack to an external device, and the external device may provide users with the state information on a target battery pack.

According to an embodiment, the state information may be provided only to an authenticated external device or an authenticated or paid user.

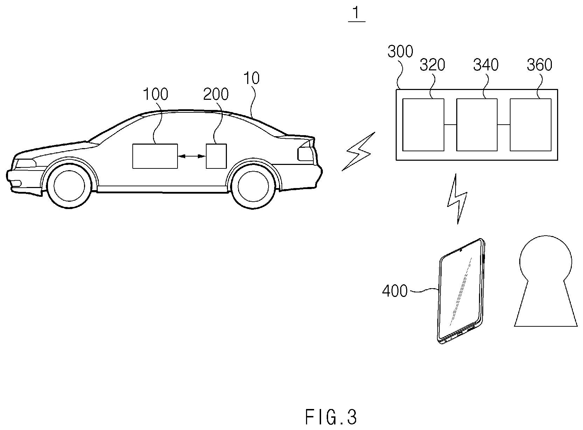

FIG. 3 is a flowchart illustrating an operation method of a battery state information provision system according to an embodiment disclosed in this document.

FIG. 3 shows a battery state information provision system 1 including a vehicle 10, a battery state information providing apparatus 300, and an external device 400.

The vehicle 10 may include a battery pack 100 and an upper-level controller 200. The battery pack 100 that is a target of state information determination may be referred to as a target battery pack.

The driving life index may be obtained when the vehicle 10 including the battery pack 100 travels actually. The driving life index may be transmitted to the battery state information providing apparatus 300 through the upper controller 200.

According to the embodiment, the battery state information providing apparatus 300 may be connected to a plurality of vehicles 10 and obtain driving life indexes from the plurality of vehicles 10. **In** addition, the battery state information providing apparatus 300 may receive experimental life indexes from a server (not shown) or a database (not shown).

The battery state information providing apparatus 300 may determine state information on target battery pack based on the driving life index and the experimental life indexes and provide the target battery pack state information to the external device 400.

The external device 400 may be a device including an output unit capable of displaying the battery pack state information. According to an embodiment, the external device 400 may be a device including an authentication means for authenticating a user and payment means for use in paying the battery pack state information and, depending on the embodiment, the external device 400 may include a mobile communication terminal, a personal digital assistant (PDA), an electronic notebook, a smartphone, a tablet personal computer (PC), and the like.

The vehicle 10, the battery state information providing apparatus 300, and the external device 400 may include a communication means capable of transmitting and receiving data to and from each other.

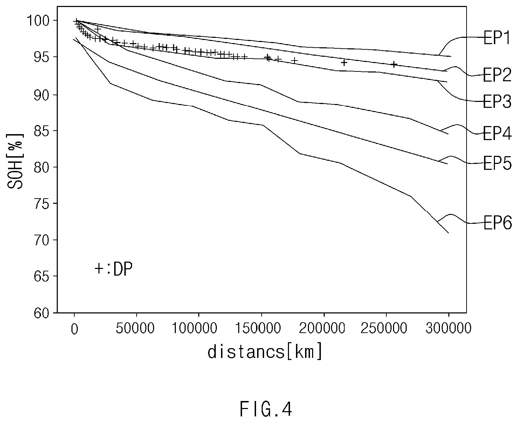

FIG. 4 is a diagram for explaining a method of determining a first evaluation profile and a second evaluation profile among a plurality of experimental profiles by a battery state information providing apparatus according to an embodiment disclosed herein.

FIG. 4 shows a driving profile DP and first to sixth experimental profiles EP1 to EP6.

The driving profile DP and the first to sixth experimental profiles EP1 to EP6 may be displayed on a plane having the travel distance and the SOH as axes.

The battery state information providing apparatus may determine an experimental profile having the highest degree of agreement with the driving profile DP among the experimental profiles EP1 to EP6 as the reference profile. For example, the battery state information providing apparatus may determine, as a reference profile, an experimental profile having the most overlapping sections with the driving profile DP.

According to an embodiment, the third experimental profile EP3 in FIG. 4 may be determined as a reference profile.

The battery state information providing apparatus may determine a first evaluation profile and a second evaluation profile by comparing the third experimental profile EP3 with the experimental profiles EP1, EP2, EP4, EP5, and EP6.

The battery state information providing apparatus may exclude the experimental profiles that are not suitable for evaluating the state of the battery pack before determining the first and second evaluation profiles.

For example, the battery state information providing apparatus may determine the experimental profiles in which a change in life index is less than 5% (e.g., EP1) or the SOH drops below 80% (e.g., EP6) for the entire driving distance (0 to 300,000 km) as inappropriate for evaluating the state of the battery pack and thus select them as neither the first evaluation profile nor the second evaluation profile.

The battery state information providing apparatus may determine, as the first evaluation profile, the experimental profile EP2 having a higher SOH value than the reference profile EP3 and having the smallest slope for the entire driving distance.

According to FIG. 4, the first experimental profile EP1 in which the change in life index is less than 5% is inappropriate for evaluating the state of the battery pack in accordance with the driving of the vehicle so as not to be selected as the first evaluation profile, and the second experimental profile EP2 may be selected as the first evaluation profile.

Also, the battery state information providing apparatus may determine, as the second evaluation profile, the experimental profile EP5 having an SOH value than that of the reference profile EP3 and having the largest slope for the entire driving distance.

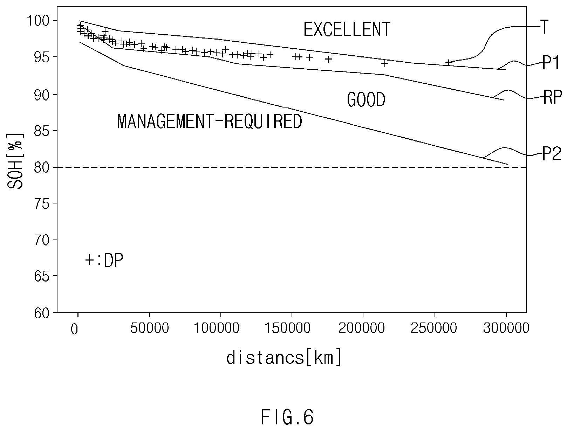

The sixth experimental profile EP6 in which the SOH drops below 80% at approximately 200000 km does not reflect the guaranteed performance of the battery pack (SOH maintains 80% or more until 300,000 km) so as not to be selected as the second evaluation profile, and the fifth experimental profile EP5 may be selected as the second evaluation profile. A method of determining state information on a target battery pack based on the first and second evaluation profiles EP2 and EP5 will be described in detail with reference to FIG. 6.

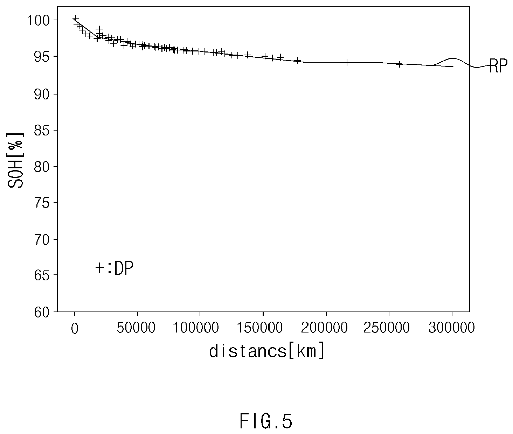

FIG. 5 is a diagram for explaining a method of determining a reference profile by a battery state information providing apparatus according to another exemplary embodiment disclosed in this document.

The battery state information providing apparatus may linearly interpolate the driving profile DP and determine a reference profile RP based on a continuous curve generated by the linear interpolation. Linear interpolation may be a method for estimating a value located between two adjacent points.

According to an embodiment, the battery state information providing apparatus may determine the reference profile RP by linearly interpolating a plurality of driving life indexes included in the driving profile DP. The reference profile RP may be a continuous curve for the entire driving distance section.

FIG. 6 is a diagram for explaining a method of determining state information about a target battery pack by a battery state information providing apparatus according to an embodiment disclosed in this document.

FIG. 6 shows a first evaluation profile P1, a second evaluation profile P2, a reference profile RP, a driving profile DP, and a target life index T of a target battery pack to be determined by state information.

The driving profile DP shown in FIG. 6 may be the same as the driving profile DP of FIG. 4. The first evaluation profile P1 may be the second experimental profile EP2 shown in FIG. 4, and the second evaluation profile P2 may be the fifth experimental profile EP5 shown in FIG. 4. Also, the reference profile RP may be the third experimental profile EP3.

The battery state information providing apparatus may compare the target life index T with the first evaluation profile P1 and the second evaluation profile P2 to determine state information on target battery pack.

Since the target life index T is higher in SOH value than the first evaluation profile P1 for the same driving distance, the battery state information providing apparatus may determine that the state of the target battery pack is excellent.

When the target life index T is lower in SOH value than the first evaluation profile P1 and higher in SOH value than the second evaluation profile P2 for the same driving distance, the battery state information providing apparatus may determine that the state of the target battery pack is good.

In addition, when the target life index T is lower in SOH value than the second evaluation profile P2 for the same driving distance, the battery state information providing apparatus may determine that the target battery pack is in a state requiring management.

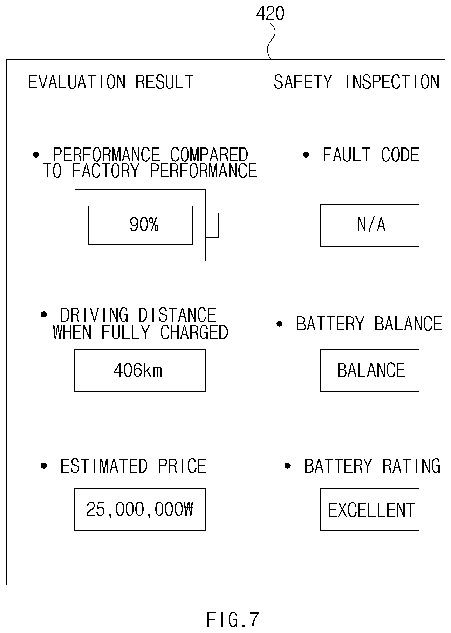

FIG. 7 is a diagram illustrating an exemplary battery state information provision screen according to an embodiment disclosed in this document.

The screen 420 may be provided in a display unit included in an external device, and the display unit may include a display or the like as an example.

The external device may provide the user with the battery pack state information received from the battery state information providing apparatus through the screen 420 .

The state information may include, for example, performance information, safety information, or price information on the target battery pack.

The performance information on the target battery pack may be displayed as a performance compared to the factory performance of the target battery pack, a driving distance when fully charged, or the like, and the battery state information providing apparatus may calculate the performance information based on the target life index of the target battery pack and the factory performance (maximum performance).

The safety information may be displayed such as whether a fault code is generated from the target battery pack or whether the battery balance is maintained. The fault code of the battery pack may be provided based on a standard code recorded in the vehicle, and the balance of the battery pack may be calculated by comparing individual voltage data and average voltage of battery cells included in the battery pack.

The price information may be displayed as an expected market price, and the battery state information providing apparatus may calculate the expected market price based on the target life index of the target battery pack and the factory performance (maximum performance).

According to an embodiment, the battery pack state information may be provided as a paid service or only to authorized users.

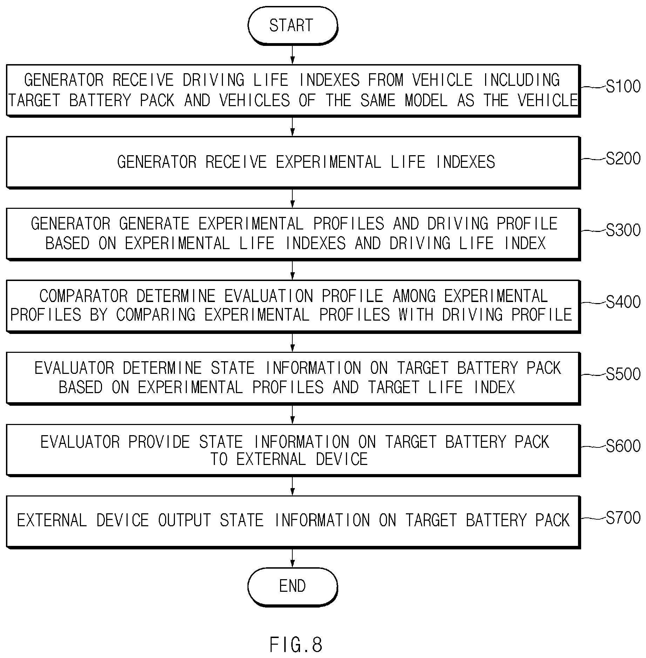

FIG. 8 is a flowchart illustrating an operation method of a battery state information provision system according to an embodiment disclosed in this document.

The generator may receive, at step S100, driving life indexes from vehicles including a target battery pack and vehicles of the same model as the vehicle.

A battery state information providing apparatus or battery state information provision system according to an embodiment of the present invention may generate a driving profile based on driving life indexes received from vehicles of the same model, thereby reflecting a change in driving life indexes of the target battery pack.

The generator may receive experimental life indexes at step S200.

The generator may receive the experimental life indexes from an external server or database, and the experimental life indexes may be battery pack life indexes for a preset experimental driving condition. That is, the experimental life indexes may be life index data obtained from charging and discharging results of charging and discharging the battery pack under experimental conditions corresponding to driving conditions. The experimental life indexes may be classified into different groups according to each driving condition.

The generator may generate, at step S300, experimental profiles and a driving profile based on the experimental life indexes and the driving life index.

The experimental profiles and driving profile may be profiles depicted on a plane with driving distance and life index (e.g., SOH) as axes. Since the experimental life indexes may be obtained for the entire driving distance for each driving condition, the experimental profiles may be continuous profiles for the entire driving distance. As many experimental profiles as the number of driving conditions may be depicted on the plane.

The driving profile can be depicted as a set of discrete points on the plane. The driving profile is an arrangement of driving life indexes collected from the vehicle and vehicles of the same model with respect to the driving distance, and since the driving life indexes are life indexes for the actual driving distance of the vehicle, the driving profile may be displayed as discontinuous points with respect to the entire driving distance.

The comparator may determine, at step S400, an evaluation profile from the experimental profiles by comparing the experimental profiles with the driving profile.

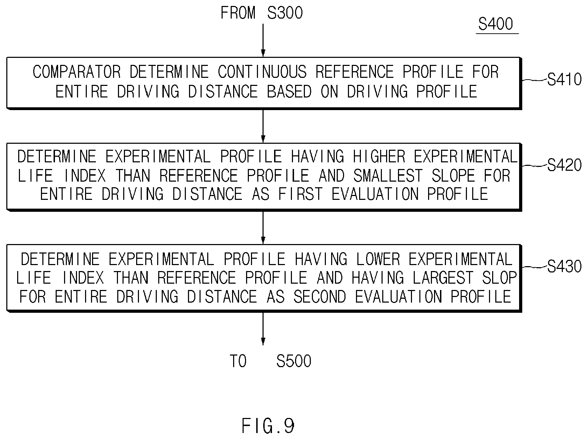

The evaluation profile may be a criterion for determining the state of the target battery pack, and the determination method of will be described in detail with reference to FIG. 9.

The evaluator may determine, at step S500, state information on the target battery pack based on the evaluation profile and the target life index.

The target life index may be a life index of the target battery pack that is subject to state determination, and the evaluator may determine whether the state of the target battery pack is excellent, good, or a state requiring management based on a relationship between the evaluation profile and the target life index.

The evaluator may provide state information on the target battery pack to an external device at step S600. The external device may include, for example, a mobile communication terminal, a personal digital assistant (PDA), an electronic organizer, a smart phone, or a user terminal such as a tablet personal computer (PC).

The external device may output the state information on the target battery pack at step S700.

The external device may include an output unit capable of outputting the state information, and the output unit may be, for example, a display. The external device may selectively output the state information on the target battery pack, and depending on the embodiment, the external device may output the state information to an authenticated user or provide the state information to a user paid for a service.

FIG. 9 is a flowchart illustrating an operation method of a battery state information provision system according to another embodiment disclosed in this document.

A method for determining a first evaluation profile and a second evaluation profile by the comparator is described with reference to FIG. 9.

The comparator may determine, at step S410, a continuous reference profile for the entire driving distance based on the driving profile.

According to an embodiment, the comparator may determine, as a reference profile, an experimental profile having the highest agreement with a driving profile among experimental profiles, by performing linear interpolation on the driving profile.

Determining the reference profile as a continuous profile for the entire driving distance facilitate comparison between the experimental profiles and the reference profile.

According to an embodiment, the comparator may not determine experimental profiles in which the change in life index is less than a preset value or the life index tends to be lower than the lowest life index for the entire driving distance as the evaluation profiles.

At step S420, the comparator may determine, as the first evaluation profile, an experimental profile having an experimental life index higher than the reference profile and having the smallest slope for the entire driving distance.

At step S430, the comparator may also determine, as the second evaluation profile, an experimental profile having an experimental life index lower than the reference profile and having the largest slope for the entire driving distance.

As the first and second evaluation profiles are selected by the battery state information providing apparatus according to an embodiment of the present invention, the shorter the driving distance, the narrower the area determined to be in good battery state, and the longer the driving distance, the wider the area determined to be in good battery state.

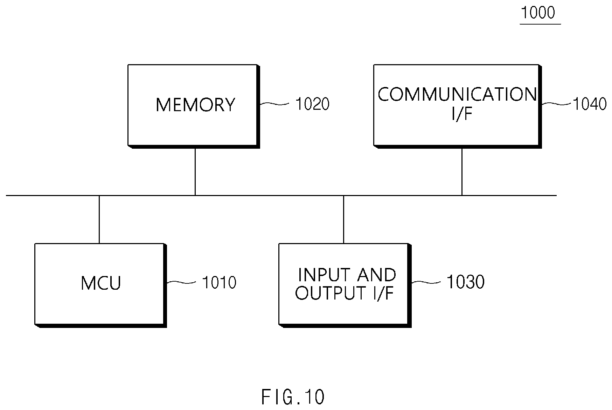

FIG. 10 is a block diagram illustrating a hardware configuration of a computing system for performing an operation method of a battery state information providing apparatus or a battery state information provision system according to an embodiment disclosed in this document.

With reference to FIG. 10, the computing system 1000 according to an embodiment disclosed in this document may include an MCU 1010, a memory 1020, an input and output I/F 1030, and a communication I/F 1040.

The MCU 1010 may execute various programs (e.g., a program for controlling a relay included in a battery pack, a program for collecting voltage, current, temperature, internal resistance, impedance, and charge and discharge count of the battery module, etc.) stored in the memory 1020 and process data for generating a driving life index via these programs. According to an embodiment, the MCU 1010 may be a processor to execute the functions of the battery management system 180 or the upper-level controller 200 that described with reference to FIG. 1 or a processor to execute the functions of the battery state information providing apparatus that described with reference to FIG. 2.

The memory 1020 may store driving life indexes and experimental life indexes of a target battery subject to state authentication and various programs related to the data processing. The memory 1020 may be provided in plurality as necessary. The memory 1020 may be a volatile memory or a non-volatile memory. The memory 1020 as a volatile memory may be RAM, DRAM, SRAM, or the like. The memory 1020 as a non-volatile memory may be ROM, PROM, EAROM, EPROM, EEPROM, flash memory, or the like. The memory 1020 is not limited to listed examples and are not limited to these examples.

The input and output I/F 1030 is an interface that connects an input device (not shown) such as a keyboard, mouse, or touch panel, an output device such as a display (not shown), and the MCU 1010 to transmit and receive data.

The communication I/F 1040 has a configuration capable of transmitting and receiving various data to and from a server and may be various devices capable of supporting wired or wireless communication. For example, the battery state information providing apparatus 300 may transmit and receive experimental life indexes or the like to and from a separately prepared external server through the communication I/F 1040. In addition, the battery state information providing apparatus 300 may transmit and receive driving life indexes to and from the upper-level controller 200 through the communication I/F 1040.

As such, a computer program according to an embodiment disclosed in this document is recorded in the memory 1020 and processed by the MCU 1010 so as to be implemented as a module that performs the functions shown in FIGS. 1 and 2.

The above description is only an illustrative example of the technical idea disclosed in this document, and those skilled in the art to which the embodiments disclosed in this document belong will be able to make various modification and changes without departing from the subject matter of the embodiments disclosed in this document.

Therefore, the embodiments disclosed in this document are not intended to limit but to describe the technical idea disclosed in this document, and the scope of the technical idea disclosed in this document is not limited by this embodiment. The scope of protection of technical ideas disclosed in this document shall be construed by the following claims, and all technical ideas within the scope equivalent thereto shall be construed as being within the scope of the rights of this document.

## Claims

1. A battery state information providing apparatus comprising:
a generator configured to generate experimental profiles and a driving profile based on experimental life indexes and driving life indexes;
a comparator configured to compare the experimental profiles and the driving profile to determine an evaluation profile among the experimental profiles; and
an evaluator configured to determine state information on a target battery pack based on the evaluation profile and a target life index,
wherein the target life index is a driving life index of a vehicle including the target battery pack.

2. The battery state information providing apparatus of claim 1, wherein the experimental profiles are profiles in which the experimental life indexes of the battery pack for a preset experimental driving condition are arranged with respect to a driving distance.

3. The battery state information providing apparatus of claim 1, wherein the driving profile is a profile in which the driving life indexes collected from the vehicle and vehicles of the same model as the vehicle are arranged with respect to a driving distance.

4. The battery state information providing apparatus of claim 1, wherein the comparator is configured to determine a continuous reference profile for an entire driving distance based on the driving profile.

5. The battery state information providing apparatus of claim 4, wherein the comparator is configured to determine, as a first evaluation profile, an experimental profile having a higher experimental life index than the reference profile and having the smallest slope for the entire driving distance.

6. The battery state information providing apparatus of claim 4, wherein the comparator is configured to determine, as a second evaluation profile, an experimental profile having a lower experimental life index than the reference profile and having the largest slope for the entire driving distance.

7. The battery state information providing apparatus of claim 4, wherein the comparator is configured to determine an experimental profile having the highest degree of agreement with the driving profile among the experimental profiles as the reference profile.

8. The battery state information providing apparatus of claim 4, wherein the comparator is configured to generate the reference profile by linearly interpolating the driving profile.

9. The battery state information providing apparatus of claim 1, wherein the evaluator is configured to authenticate the state information and provide the authenticated state information to an external device.

10. The battery state information providing apparatus of claim 1, wherein the state information comprises performance information, safety information, or price information on the target battery pack.

11. A battery state information provision system comprising:
a vehicle comprising a target battery pack and a controller configured to transmit a driving life index for the target battery pack;
a battery state information providing apparatus configured to receive experimental life indexes and a driving life index and determine state information on the target battery pack based on the experimental life indexes and the driving life index; and
an external device configured to output the state information on the target battery pack.

12. The battery state information providing system of claim 11, wherein the external device is configured to output the state information to an authenticated user.

13. The battery state information providing system of claim 11, wherein the experimental life indexes are life indexes of the battery pack under a preset experimental driving condition.

14. The battery state information providing system of claim 11, wherein the driving life index is a life index collected from the vehicle and vehicles of the same model as the vehicle.

15. An operation method of a battery state information provision system, the operation method comprising:
receiving, at a generator, driving life indexes from a vehicle including a target battery pack and vehicles of the same model as the vehicle;
receiving, at the generator, experimental life indexes;
generating, at the generator, experimental profiles and a driving profile based on the experimental life indexes and the driving life indexes;
determining, at a comparator, an evaluation profile among the experimental profiles by comparing the experimental profiles with the driving profile;
determining, at an evaluator, state information on the target battery pack based on the evaluation profile and a target life index;
providing, at the evaluator, the state information on the target battery pack to an external device; and
outputting, at the external device, the state information on the target battery pack,
wherein the target life index is a driving life index of the vehicle.

16. The operation method of claim 15, wherein the experimental profiles are profiles in which the experimental life indexes of the battery pack for a preset experimental driving condition are arranged with respect to a driving distance.

17. The operation method of claim 15, wherein the driving profile is a profile in which the driving life indexes collected from the vehicle and vehicles of the same model as the vehicle are arranged with respect to a driving distance.

18. The operation method of claim 15, wherein determining the evaluation profile comprises:
determining, at the comparator, a continuous reference profile for an entire driving distance based on the driving profile;
determining, as a first evaluation profile, an experimental profile having a higher experimental life index than the reference profile and having the smallest slope for the entire driving distance; and
determining, as a second evaluation profile, an experimental profile having a lower experimental life index than the reference profile and having the largest slope for the entire driving distance.

19. The operation method of claim 18, wherein determining the reference profile comprises determining an experimental profile having the highest degree of agreement with the driving profile among the experimental profiles as the reference profile.

20. The operation method of claim 18, wherein determining the reference profile comprises generating the reference profile by linearly interpolating the driving profile.

21. A battery state information provision system comprising:
battery state information providing apparatus configured to receive experimental life indexes and a driving life index of a target battery pack and determine state information on the target battery pack based on the experimental life indexes and the driving life index; and
an external device configured to display the state information,
wherein the battery state information providing apparatus authenticates the state information, and the status information comprises performance information, safety information, or price information on the target battery pack.
